(19)

**Europäisches Patentamt**
**European Patent Office**
**Office européen des brevets**

(11) **EP 4 560 400 A1**

(12) **EUROPEAN PATENT APPLICATION**

(43) Date of publication:
**28.05.2025 Bulletin 2025/22**

(21) Application number: **23212371.1**

(22) Date of filing: **27.11.2023**

(51) International Patent Classification (IPC):
**G03F 7/20** *(2006.01)* **G01N 23/00** *(2006.01)*
**G02B 21/36** *(2006.01)* **G01N 21/84** *(2006.01)*
**G01N 21/956** *(2006.01)* **G01N 21/47** *(2006.01)*

(52) Cooperative Patent Classification (CPC):
**G03F 7/70605; G01N 21/4788; G01N 21/956; G01N 23/00; G03F 7/70633;** G01N 2021/8438

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Stichting Nederlandse Wetenschappelijk Onderzoek Instituten**
**3526 KV Utrecht (NL)**
• **Stichting VU**
**1081 HV Amsterdam (NL)**

• **Universiteit van Amsterdam**
**1012 WX Amsterdam (NL)**
• **ASML Netherlands B.V.**
**5500 AH Veldhoven (NL)**

(72) Inventors:
• **GOUDER, Matthias, Carl**
**3526 KV Utrecht (NL)**
• **WITTE, Stefan, Michiel**
**1081 HV Amsterdam (NL)**

(74) Representative: **ASML Netherlands B.V.**
**Corporate Intellectual Property**
**P.O. Box 324**
**5500 AH Veldhoven (NL)**

(54) **METHOD FOR DETERMINING AN OPTICAL PROPERTY OF A MULTI-LAYER STRUCTURE**

(57)    A method of determining optical property of a structure, comprising: obtaining first scattering data, the first scattering data relating to an illumination of the multi-layer structure with illumination radiation in a first polarization state and subsequently capturing radiation scattered from the multi-layer structure; reconstructing one or more first synthetic images of the multi-layer structure using the first scattering data, each of the one or more first synthetic images comprising amplitude and phase information of the radiation scattered from the multi-layer structure; and determining the optical property of the multi-layer structure using the one or more first synthetic images, wherein the optical property comprise complex refractive indices of one or more of the at least two layers of the multi-layer structure, and/or relative heights formed between the at least two layers of the multi-layer structure.

**EP 4 560 400 A1**

MLS

$n_2, k_2, h_2$

STR2

$n_1, k_1, h_1$

STR1

SUB

**Fig. 9A**

**Description**

FIELD

The present invention relates to a method of determining an optical property of a multi-layer structure comprising at least two layers of different materials.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a scattering pattern similar to that observed from the real target.

In addition to measurement of feature shapes by reconstruction, diffraction-based overlay can be measured using such apparatus, as described in published patent application US2006/066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011/102753A1 and US2012/044470A1. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray (SXR) and/or EUV radiation) may be using a pump radiation (e.g., infrared IR radiation) to excite a generating medium, thereby generating an emitted radiation, optionally a high harmonic generation comprising high frequency radiation.

It is desirable to improve the accuracy of semiconductor metrology or inspection.

## SUMMARY

According to a first aspect of the invention, there is provided a method of determining an optical property of a multi-layer structure comprising at least two layers of different materials, comprising: obtaining first scattering data, the first scattering data relating to an illumination of the multi-layer structure with an illumination radiation in a first polarization state and subsequently capturing radiation scattered from the multi-layer structure; reconstructing one or more first synthetic images of the multi-layer structure using the first scattering data, each of the one or more first synthetic images comprising amplitude and phase information of the radiation scattered from the multi-layer structure; and determining the optical property of the multi-layer structure using the one or more first synthetic images, wherein the optical property comprise complex refractive indices of one or more of the at least two layers of the multi-layer structure, and/or relative heights formed between the at least two layers of the multi-layer structure.

According to a third aspect of the invention, there is provided a method for measuring an optical-property-related parameter of a structure on a substrate, comprising obtaining first scattering data, the first scattering data relating to measuring a multiple of first scattered illuminations from multiple illumination spots covering different areas of the structure illuminated from an incident illumination with a first polarization, wherein each of the multiple illumination spots partly overlaps with a least one of the other illumination spots; obtaining second scattering data, the second scattering data relating to measuring a multiple of second scattered illuminations from multiple illumination spots covering different areas of the structure illuminated from the incident illumination with a second polarization, wherein each of the multiple illumination spots partly overlaps with a least one of the other illumination spots, and wherein the second polarization is different from the first polarization; and calculating the optical-property-related parameter of the structure based on the first scattering data and the second scattering data.

According to a third aspect of the invention, there is provided a computer program comprising program instructions operable to perform the method according to the first or second aspect, when run on a processing resource.

According to a forth aspect of the invention, there is provided a lithographic tool for measuring and/or inferring properties of a patterned structure on a substrate, comprising a non-transient computer program carrier comprising a computer program according to the third aspect.

## BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus configured for performing coherent diffraction imaging (e.g., ptychography, scatterometry);
- Figure 7 depicts the mapping of diffraction angles to pixels on a planar detector in the apparatus of Figure 6;
- Figures 8A-8C depict obtaining of scattering patterns from overlapping portions of a target structure for performing ptychography with the apparatus of Figure 6;
- Figures 9A-9B schematically illustrate a top view and a side view of a simplified multi-layer structure MLS, respectively;

- Figures 9C-9D schematically illustrate a first synthetic image IMA1 and a second synthetic image IMA2 of the multi-layer structure obtained with s-polarized and p-polarized illumination radiation, respectively; and
- Figures 10A-10C schematically illustrate three example arrangements configured for polarization sensitive ptychography measurements.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

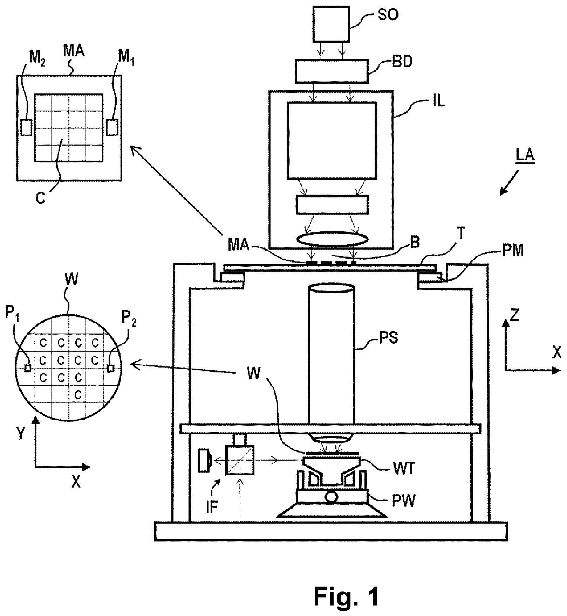

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253B2, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

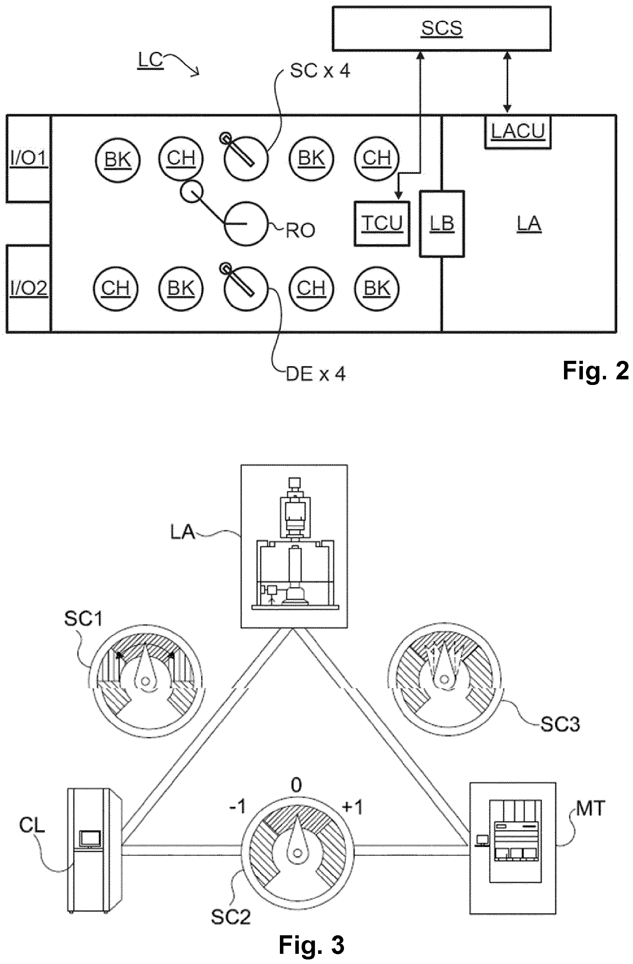

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US2010/0328655A1, US2011/102753A1, US2012/044470A1, US2011/0249244A1, US2011/026032A1 or EP1628164A2, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a scattering pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patents US7791724B2, US7701577B2, US8115926B2, US8553227B2, US8681312B2, US8792096B2, US8823922B2, US8692994B2, US13/533110 and US8797554B2 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1628164A2, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO2011/012624A1 or US patent application US2016/161863A1, incorporated herein by reference in its entirety.

Other parameters of interest may be focus and dose. Focus and dose may be determined simultaneously by scatterometry (or alternatively by scanning electron microscopy) as described in US patent application US2011/249244A1, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/161863A1 and published US patent application US2016/370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due optical property of many semiconductor materials, and due to the structures being comparable in size to the probing wavelength. As a result, EUV and/or soft X-ray metrology tools MT may operate in reflection, for example by imaging, or by analysing scattering patterns from, a lithographically patterned structure. A optical-property-related parameter may also be considered as an optical property.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

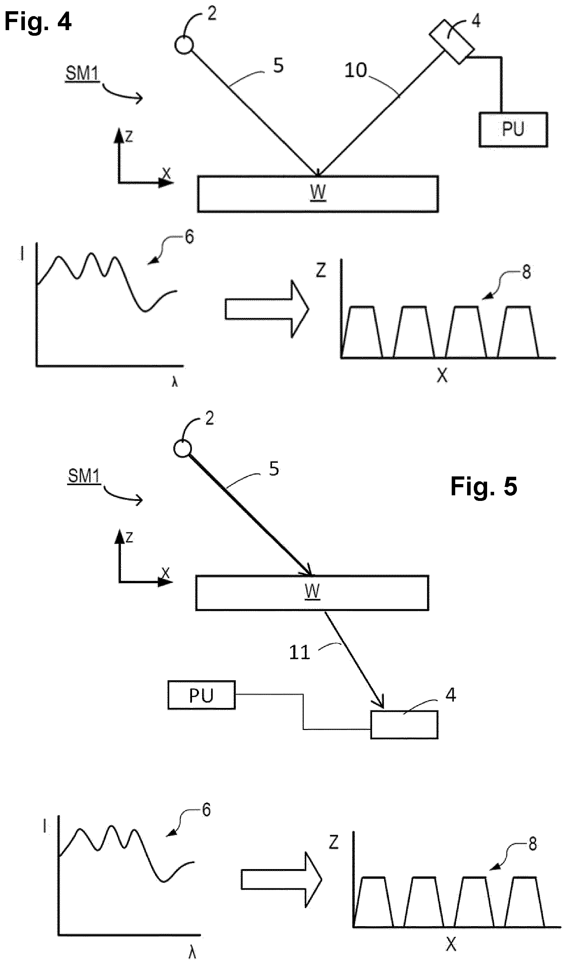

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US2007224518A1 which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication US2019 /003988A1, and in U.S. Patent Publication US2019/215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles (or called incident angles) may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US2013/304424A1 and US2014/019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

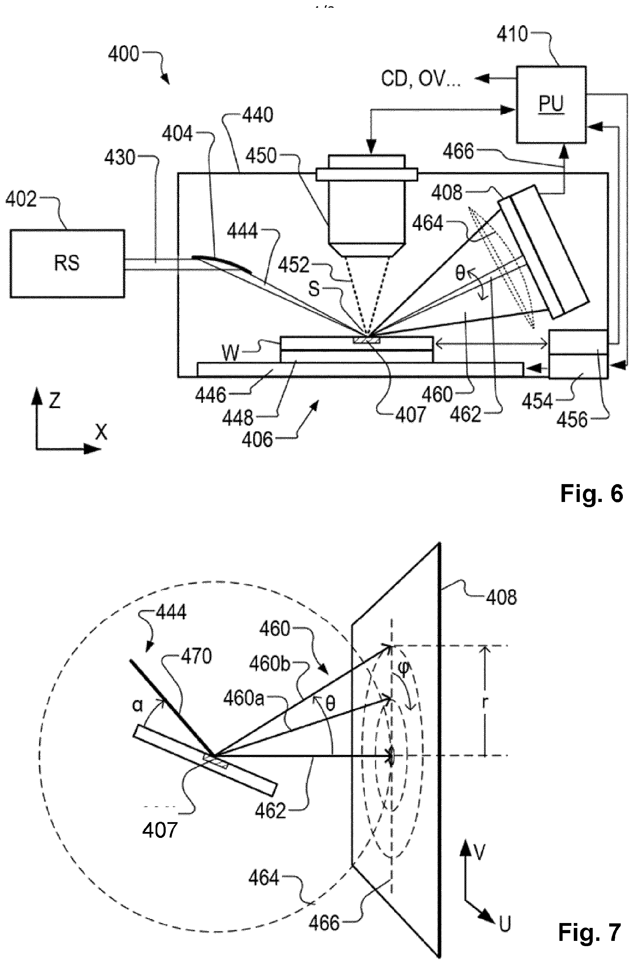

Figure 6 illustrates a schematic physical arrangement of a metrology apparatus 400 configured for performing coherent diffraction imaging (CDI) and comprising a radiation source 402, illumination optical system 404, substrate support 406, detector 408 and processor 410. Radiation source 402 may be of any type and may provide output radiation of any desired wavelength or wavelengths. In an example implementation, radiation source 402 may comprise a generator of EUV or x-ray radiation based on high harmonic generation (HHG) techniques. The radiation for the purpose of CDI should be spatially coherent but it may contain multiple wavelengths. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. The various components of radiation source 402 and illumination optics 404 can be adjustable to implement different metrology 'recipes' within the same apparatus. For example different wavelengths and/or polarization can be made selectable.

From the radiation source 402, a radiation beam 430 enters an inspection chamber 440 where the substrate W including a structure of interest is held for inspection by substrate support 406. The structure of interest is labeled 407. The structure of interest may be a portion of a non-periodic product area. The structure of interest may be a portion of a periodic product area. The atmosphere within inspection chamber 440 may be maintained near vacuum by vacuum pump (not shown). The Illumination optics 404 has the function of focusing the radiation into a focused beam 444, and may comprise for example a two-dimensionally curved mirror (or a series of one-dimensionally curved mirrors) or one or more lenses. The focusing is performed to achieve a round or elliptical spot S with a spot diameter e.g., between 1 and 100 $\mu$m, when projected onto the structure of interest 407. Substrate support 406 comprises for example an X-Y translation stage 446 and a rotation stage 448, by which any part of the substrate W can be brought to the focal point of beam 444 in a desired orientation. Thus the radiation spot S is formed on the structure of interest 407.

Tilting of the substrate W in one or more dimensions may also be provided. To aid the alignment and focusing of the spot S with desired product structures, auxiliary optics 450 uses auxiliary radiation 452 under control of processor 410. Processor 410 can also communicate with a position controller 454 which operates the stages 446 and 448. Processor 410 receives highly accurate feedback on the position and orientation of the substrate, via sensors 456. Sensors 456 may include interferometers, for example, which can give accuracy in the region of picometers.

Detector 408 captures radiation 460 that is scattered by the product structure S over a range of angles θ in two dimensions. A specular beam 462 represents a "straight through" portion of the radiation. This specular beam may optionally be blocked by a stop (not shown), or pass through an aperture in detector 408. In a practical implementation, images with and without the central stop may be taken and combined to obtain a high dynamic range (HDR) image of a scattering pattern, optionally a diffraction pattern. The range of angles of diffraction can be plotted on a notional sphere 464, known in the art as the Ewald sphere, while the surface of the detector 408 will more conveniently be flat. Detector 408 may be for example a CCD or CMOS image detector comprising an array of pixels. Detector 408 may be operable to rotate around the substrate in such a manner that it always captures the scattered radiation 460 when the substrate W is tilted about the X or Y axis.

Figure 7 (not to scale) illustrates the mapping of diffraction angles (and consequently points on the Ewald sphere 464) to pixels on a planar detector 408. The dimensions of the pixel array are labeled U, V in a pseudo-perspective representation. The diffracted radiation 460 is deflected by a sample product structure 407 at a point that defines the center of the Ewald sphere 464. Two rays 460a and 460b of the diffracted radiation are scattered by the product structure S, with respective angles $\theta$ relative to the specular ray 462. Each ray 460a, 460b passes through a point on the (notional) Ewald sphere impinges on a particular point in the (actual) U-V plane of detector 408, where it is detected by a corresponding pixel detector. Knowing the geometry of the apparatus within the inspection chamber 440, processor 410 is able to map pixel positions in an image captured by detector 408 to angular positions on the Ewald sphere 462. For convenience, the specular portion 462 of the reflected radiation is aligned with the horizontal direction in the diagram, and a direction normal to the plane of detector 408. This arrangement simplifies the imaging calculations, but any coordinate system can be chosen. Thus a radial distance r on detector 408 can be mapped to an angle $\Theta$. A second angular coordinate $\varphi$ represents deflection out of the plane of the diagram, and can be mapped also from the position on the detector. Only rays with $\varphi = 0$ are shown in this illustration, corresponding to pixels on a line 466 on the detector.

Returning to Figure 6, pixel data 466 is transferred from detector 408 to processor 410. Using lensless imaging, a 3-D image (model) of the target can be reconstructed from the scattering pattern captured on the image detector. From the reconstructed image, together with knowledge of the intended pattern defects are identified by processor 410 and reported to the operator and control systems of the lithographic manufacturing facility. Note that the processor 410 could in principle be remote from the optical hardware and inspection chamber. Functions of the processor could be divided between local and remote processing units, without departing from the principles disclosed herein. For example, a local processor may control the apparatus to capture images from one or more product structures on one or more substrates, while a remote processor processes the pixel data to obtain measurements of the structure. The same processor or yet another processor could form part of the supervisory control system SCS or lithographic apparatus controller LACU and use the measurements to improve performance on future substrates.

As mentioned, the metrology apparatus of Figure 6 is arranged to perform CDI. Various techniques for CDI are described in the PhD thesis describing lensless imaging at EUV wavelengths is "High-Resolution Extreme Ultraviolet Microscopy" by M.W. Zürch, Springer Theses, DOI 10.1007/978-3-319-12388-2_1.

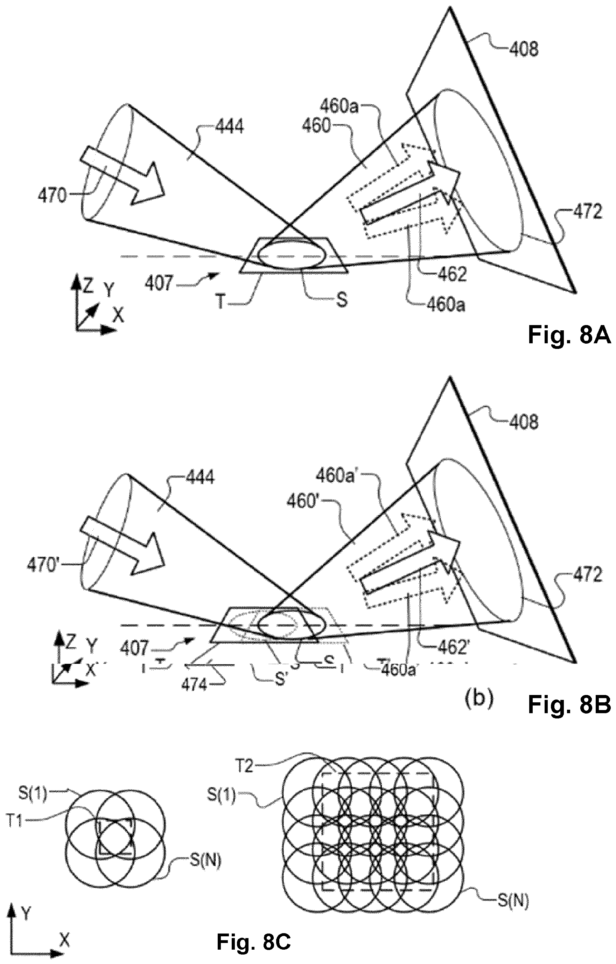

Referring to Figures 8A-8C, a particular type of CDI is ptychography, described for example in published patent application US2010241396A1 and US patents US7792246B2, US8908910B2, US8917393B2, US8942449B2, US9029745B2 of the company Phase Focus Limited and the University of Sheffield. D. Claus et al provide an introduction to ptychography in a paper "Ptychography: a novel phase retrieval technique, advantages and its application" Proc. SPIE 8001, International Conference on Applications of Optics and Photonics, 800109 (July 26, 2011); doi:10.1117/12.893512. In ptychography, phase information is retrieved from a plurality of captured images with an illumination field that is moved slightly between successive captures. Overlap between the illumination fields allows reconstruction of phase information and 3-D images. Other types of CDI can be considered also.

In Figure 8A, we see the incident beam 444, the scattered beam 460 and the detector 408 during capture of one image of the scattering pattern. The structure of interest 407 is represented by a square target area T. The focused spot S is at a first position, for example in the middle of the target area. Incident rays 470 are represented, specular rays 462 and scattered rays 460a, 460b, corresponding to the like-numbered rays in Figure 7. It will be appreciated that these rays are only representative, and within the beams 444 and 460 rays are spread over a range of angles of incidence and scattering. From each point within the spot S, specular rays 462 are incident at all points within area 472 on the detector. Scattered rays 460a, 460b similarly can be incident at any point on the detector 408. Consequently, as explained in the Claus *et al* paper, diffraction orders of structures of interest 407 within the spot S overlap with one another to form the scattering pattern captured by detector 408. The radiation in beam 444 is spatially coherent, within the spot area S.

While full spatial coherence across the spot area would simplify calculations, it is found that partial coherence can be sufficient for good diffraction imaging, provided additional steps are applied in calculations. A survey of research in his area is provided in the presentation "Coherence and partial coherence - what do we need?" by Ian McNulty, Center for Nanoscale Materials, Argonne National Laboratory, USA, at the MBA Lattice Workshop, Advanced Photon Source, 21-22 October 2013 (retrieved from the Internet 11 August 2015). These and further techniques are reviewed in a presentation "Partial coherence in diffractive X-ray imaging: towards biomolecular structure determination" by Harry Quiney, ARC Centre for Coherent X-ray Science, School of Physics, The University of Melbourne (retrieved from Internet 11 August 2015). In one such technique, the partially coherent radiation is modeled as superposition of a few spatially coherent modes. CDI can be performed by optimizing for each mode individually providing for these modes individually within the CDI algorithm, rather than trying to treat the radiation as coherent. This technique is described further in "Diffractive Imaging Using Partially Coherent X Rays" by L. W. Whitehead et al, Phys. Rev. Lett. 103, 243902 (2009), the contents of which are incorporated herein by reference.

At Figure 8C we see the capturing of a second scattering pattern. At least two patterns are required for ptychography. The process is identical to that shown in Figure 8A. A small displacement 474 (in this illustration a translation in the X direction) has been made between the substrate and the incident beam which is now labeled 444'. As mentioned, the apparatus can record such displacement very accurately using sensors 456. Details of the displacement 474 are recorded, along with the captured scattering patterns. In a practical implementation, adapted for use in semiconductor manufacturing, the source and other optical components will likely remain stationary, while the substrate with target are T moves to a new position using stages 446, 448 under control of processor 410. In principle, the structure of interest 407 could remain stationary while the other components move. The spot S now falls on target area T with a spot area different from, but significantly overlapping the former position S'. The former position of target area T is shown as T'. Scattered rays 460a', 460b' are captured on detector 408 as before. The scattering pattern, which records only intensity, may be very similar to that captured in Figure 8A, but slight differences between the patterns can be used to reconstruct phase information, thanks to the overlapping of the spot areas S and S'. The degree of overlap between adjacent spot areas may be greater than 30%, for example around 50% of the spot area.

More than two scattering patterns may be captured, as required. Figure 8C shows two examples where a target areas T1 and T2 are each covered by a series of displaced radiation spots S(1) to S(N), all mutually displaced in X and/or Y directions but all overlapping significantly one or more of their neighbors. The area that is covered by the calculated image corresponds to those areas where at least two spots overlap, so the rectangular areas T1, T2 could in principle be extended into a more complex shape if desired. Nevertheless, it will be appreciated that the synthesized image might cover a target area T1 that is only for example 2 $\mu$m by 2 $\mu$m, in the case of area T1. Even so, it may encompass many hundreds or even thousands of functional devices within a product (e.g., a DRAM chip). Consequently, only two or a few captures may be required in a practical inspection task.

Metrology typically uses accurate knowledge of the optical property/properties of materials in a stack, in particular coefficients (n and k) of the complex refractive index (N = n - ik), and the thickness of a layer. These properties are important to model the optical response of a stack in a metrology tool, and to interpret results and correct for potential systematic effects. A complicating factor is that in thin films of a material, n and k can be very different from the values for bulk material, therefore often requiring dedicated measurements.

Ellipsometry is the standard method to determine parameters like n and k. This is achieved by measuring absolute reflectivity for different polarization states of incident light, which is often combined with multiple reflection angles and/or wavelengths of the illumination. Combining this measurement data with a nominal model of the layer structure and a parameter estimation algorithm enables retrieval of n, k and height for various materials. However, ellipsometry is not an imaging technique, and typically averages over an extended illumination spot size, leading to low spatial resolution. This makes it difficult to determine the optical property/properties of small areas and/or structured surfaces. Combining an ellipsometer with a wide-field microscope is impractical as such a device needs to operate over an extended range of angles and wavelengths. Therefore, it is the object of the present disclosure to propose a method that not only avoids or mitigates the above mentioned issues but also allows determination of the optical property of thin films in a stack in a more accurate and robust manner.

According to a first aspect of the present disclosure, there is provided a method of determining an optical property or optical properties of a structure, optionally a multi-layer structure comprising at least two layers of different materials. Some or all of the at least two layers of the multi-layer structure may be thin films which may have a thickness of for example from several nanometers to about several micrometers (e.g., between 1nm and 10$\mu$m). Optionally the multi-layer structure comprises a periodic structure. Optionally the multi-layer structure comprises a non-periodic structure. Optionally the multi-layer structure comprises both a periodic structure and a non-periodic structure.

The proposed method may comprise: obtaining first scattering or diffraction data, the first scattering or diffraction data relating to an illumination of the multi-layer structure with illumination radiation in a first polarization state and subsequently capturing radiation scattered from the multi-layer structure; optionally reconstructing one or more first synthetic images of the multi-layer structure using the first scattering or diffraction data; wherein the first scattering or diffraction data, optionally each of the one or more first synthetic images, comprising amplitude and phase information of the radiation scattered from the multi-layer structure; and determining the optical property/properties of the multi-layer structure using the one or more first synthetic images.

The proposed method may be implemented by a processing resource, such as a processor. A processing resource may be implemented using a cloud-implemented computing resource or using a local computing resource. A processing resource may be any resource which can provide computer processing capability.

The proposed method may be implemented with data obtained by ptychography measurements. Ptychography measurements or other measurements are taken to retrieve maps (synthetic images), optionally high-resolution maps, of parameters of the structure, e.g. n, k and height on structured surfaces containing different materials. Ptychography measurements may be performed on a metrology apparatus such as the example arrangement 400 shown in Figure 6 (various other arrangements configured for ptychography measurements will be described in the following paragraphs). Ptychography retrieves, via image reconstruction, quantitative amplitude and phase maps of the imaged area at high spatial resolution, without systematic offsets from optics, reference beams and/or the illumination radiation itself. Because of this property, phase shifts between different points on a surface can be accurately determined. By measuring such phase shifts for either a single polarization state or two different polarization states of the illumination radiation, and the (simultaneously determined) reflection or reflectivity ratios between any two of the at least two layers (see below for more details), sufficient data can be obtained to determine the coefficients (n and k) of the complex refractive index for each of the at least two layers and the relative heights between the at least two layers.

Accordingly, in an embodiment, the first scattering or diffraction data may comprise at least one first plurality of scattering patterns, the at least one first plurality of scattering patterns relating to an illumination of the multi-layer structure respectively with at least one first plurality of spots of illumination radiation in the first polarization state and subsequently capturing the radiation scattered from the multi-layer structure for each spot of illumination radiation. Each of the at least one first plurality of spots of illumination radiation may correspond to a different angle of incidence and/or different wavelength of the illumination radiation, and spots of each of the at least one first plurality of spots of illumination radiation may be partly overlapping, i.e. spatially displaced from one another but overlapping in plane of the substrate, from one another. Each scattering pattern of the at least one first plurality of scattering patterns may be associated with one spot of the at least one first plurality of spots of illumination radiation. The one or more first synthetic images of the multi-layer structure may be reconstructed using respectively the at least one first plurality of scattering patterns and knowledge of a relative displacement of each of the at least one first plurality of spots of illumination radiation.

In an embodiment, the method may further comprise obtaining second scattering or diffraction data, the second scattering or diffraction data relating to an illumination of the multi-layer structure with illumination radiation in a second polarization state, different to the first polarization state, and subsequently capturing radiation scattered from the multi-layer structure; reconstructing one or more second synthetic images of the multi-layer structure using the second scattering or diffraction data, the second scattering or diffraction data, optionally each of the one or more second synthetic images comprising amplitude and phase information of the radiation scattered from the multi-layer structure; and wherein the optical property of the multi-layer structure are determined using the one or more first synthetic images and the one or more second synthetic images.

In an embodiment, the second scattering or diffraction data may comprise at least one second plurality of scattering patterns by illuminating the multi-layer structure respectively with at least one second plurality of spots of illumination radiation in a second polarization state and subsequently capturing radiation scattered from the multi-layer structure for each of the at least one second plurality of spots of illumination radiation. Each of the at least one second plurality of spots of illumination radiation may correspond to a different angle of incidence and/or different wavelength of the illumination radiation, and spots of each of the at least one second plurality of spots of illumination radiation may be overlapping or partly overlapping (partly overlapping means displaced from one another but overlapping) from one another. Each scattering pattern of the at least one second plurality of scattering patterns may be associated with one spot of the at least one second plurality of spots of illumination radiation. The one or more second synthetic images of the multi-layer structure may be reconstructed using respectively the at least one second plurality of scattering patterns and knowledge of a relative displacement of each of the at least one second plurality of spots of illumination radiation.

In an embodiment, the optical property may comprise for example refractive indices of one or more of the at least two layers of the multi-layer structure, and/or relative heights formed between the at least two layers of the multi-layer structure.

In an embodiment, the step of determining the optical property of the multi-layer structure further comprises: determining a reflectivity of each of the at least two layers in the first polarization state and/or the second polarization state, a phase difference between any two of the at least two layers, and a phase shift resulting from a relative height formed between any two of the at least two layers by using the one or more first synthetic images and/or the one or more second synthetic images; defining one or more sets of functions, wherein each set of functions is associated with two of the at least two layers of the multi-layer structure, and wherein each function comprises a combination of Fresnel equations and relating to an angle of incidence and/or a wavelength of the illumination radiation, a relative height formed between the two layers, and refractive indices of the two layers in the first polarization state and/or the second polarization state; calculating a value for each function using the determined reflectivities, the determined phase differences, and/or the determined phase shifts; and determining a reflective index for each of the at least two layers, and a relative height between any two of the at least two layers by matching the defined functions to the respective determined values.

In an embodiment, each set of functions may comprise: a first function which may be expressed as a first ratio of a first reflectivity in the first polarization state of a first layer of the at least two layers over a second reflectivity in the second polarization state of the first layer of the at least two layers; a second function which may be expressed as a second ratio of a third reflectivity in the first polarization state of a second layer of the at least two layers over a fourth reflectivity in the second polarization state of the second layer of the at least two layers; a third function which may expressed as a third ratio of the first reflectivity over the third reflectivity multiplied by an exponential function of (the imaginary unit multiplied by a difference between a first phase in the first polarization state of the first layer and a third phase in the first polarization state of the second layer); and a fourth function which may be expressed as a fourth ratio of the second reflectivity over the fourth reflectivity multiplied by an exponential function of (the unit imagery multiplied by a difference between a second phase in the second polarization state of the first layer and a fourth phase in the second polarization state of the second layer).

In an embodiment, the matching step comprises minimizing differences between the one or more sets of functions and their respective corresponding determined values.

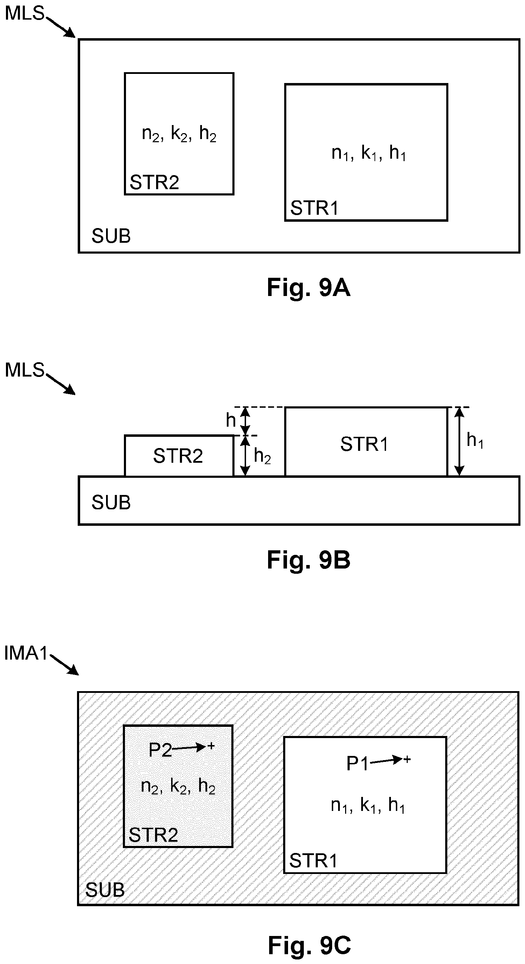

For the sake of simplicity and by way of example, the working principle of the proposed method (in particular the step of determining the optical property of the multi-layer structure) will be described based on a simplified multi-layer structure. Figures 9A and 9B schematically illustrate a top view and a side view of a simplified multi-layer structure MLS, respectively. As shown in Figures 9A and 9B, the multi-layer structure MLS comprises a substrate SUB and two spatially separated structured (thin film) layers STR1, STR2 deposited on the top surface of the substrate SUB. The first structured layer STR1 has a first complex refractive index expressed as $\tilde{n}_1 = n_1 - ik_1$ and a first height $h_1$. The second structured layer STR2 has a second complex refractive index expressed as $\tilde{n}_2 = n_2 - ik_2$ and a second height $h_2$. The relative height h is the difference between the first height $h_1$ and the second height $h_2$. Optionally the relative height h is zero. Optionally the material of the first structure layer may be the same as the material of the second structure layer. Optionally the material of the first structure layer may be different than the material of the second structure layer. Optionally one of the materials of the first structure layer and the second structure layer is photoresist. Optionally one of the materials of the first structure layer and the second structure layer is air/vacuum.

A first plurality of scattering patterns can be obtained by performing measurements on the multi-layer structure, and for this embodiment, the performed measurements comprises measuring a multiple of first scattered illuminations from a first multiple illumination spots covering different areas of the structure illuminated from an incident illumination, optionally with a first polarization, wherein optionally each of the first multiple illumination spots (partly) overlaps with a least one of the other of the first multiple illumination spots.

Optionally a first plurality of scattering patterns and a second plurality of scattering patterns can be obtained by performing measurements on the multi-layer structure. For this embodiment, the performed measurements comprises measuring a multiple of first scattered illuminations from a first multiple illumination spots covering different areas of the structure illuminated from an incident illumination, with a first polarization or called polarization state, wherein optionally each of the first multiple illumination spots partly overlaps with a least one of the other the first illumination spots, and measuring a multiple of second scattered illuminations from the second multiple illumination spots covering different areas of the structure illuminated from the incident illumination with a second polarization, wherein optionally each of the second multiple illumination spots partly overlaps with a least one of the other of the second illumination spots. Optionally the second polarization is different from the first polarization. Optionally the second polarization is orthogonal/perpendicular to the first polarization. Optionally the second polarization is different from the first polarization but is not orthogonal/perpendicular to the first polarization. Optionally the measurements performed is a ptychography. Optionally a first plurality of scattering patterns and a second plurality of scattering patterns can be obtained by performing measurements on the multi-layer structure for the first polarization state (e.g., the s-polarization state) and the second polarization state (e.g., the p-polarization state), respectively. Optionally the method further comprises calculating a parameter of interest, optionally an optical-property-related parameter, optionally a refractive index parameter, of the structure(s), based on the measured multiple of first scattered illuminations and the measured multiple of second scattered illuminations. The first plurality of scattering patterns and the second plurality of scattering patterns, along with values of the relative displacements between illumination spots, may be stored as image data in a memory. Such image data may be input into a phase retrieval algorithm (e.g., existing phase retrieval algorithms for ptychography) to reconstruct the full complex field of the radiation diffracted from the multi-layer structure MLS for each of the first polarization state (e.g., the s-polarization state) and the second polarization state (e.g., the p-polarization state). Each reconstructed full complex field may then be used to generate a quantitative amplitude and phase image (e.g., the first synthetic image or the second synthetic image) of the multi-layer structure MLS.

In one embodiment, the different polarizations are replaced by different wavelengths.

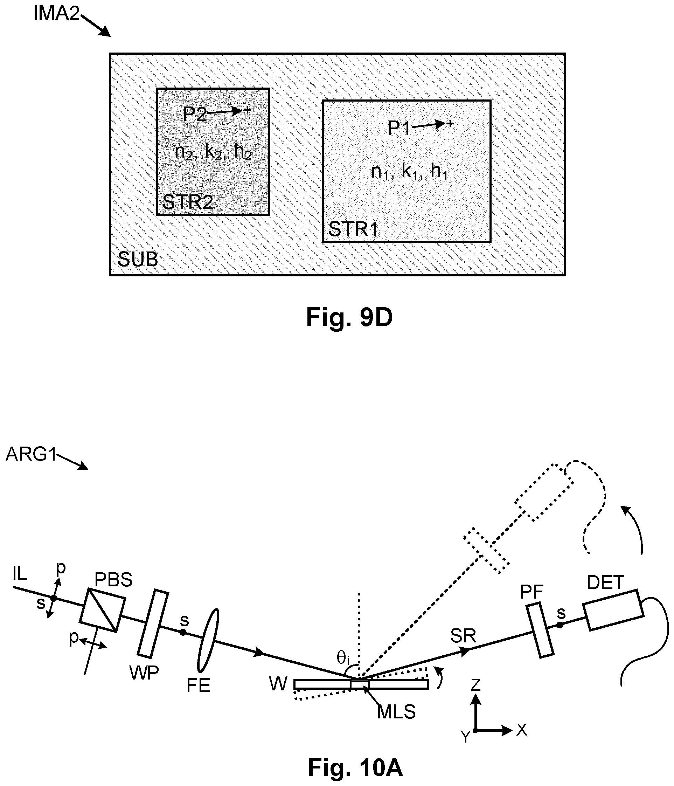

Figures 9C and 9D schematically illustrate a first synthetic image IMA1 and a second synthetic image IMA2 of the multi-layer structure obtained with s-polarized and p-polarized illumination radiation, respectively. The amplitude and phase (not absolute) of the diffracted radiation at each pixel position can be directly obtained from the first synthetic image IMA1 or the second synthetic image IMA2. For a given position on the image IMA1 or IMA2, the reconstructed amplitude (or intensity) the diffracted radiation and the measured amplitude (or intensity) of the illumination radiation can be used to determine a reflectivity at the position.

With reference to Figures 9C and 9D, a first position P1 is selected on the first structured layer STR1 and a second position P2 is selected on the second structured layer STR2. The first position P1 and the second position P2 may be randomly selected as long as they are on the respective surfaces of the first structured layer STR1 and the second structured layer STR2. In a preferred implementation, instead of selecting a single position on a structured layer, an area of each structured layer may be selected. The amplitudes and phases within the selected area may then be averaged to obtain an averaged amplitude and an averaged phase. This can improve the accuracy of the final determined optical property.

Based on the amplitude and phase information provided by the scattering or diffraction data, optionally by synthetic images IMA1 and IMA2 and the measured power or intensity of the illumination radiation, it is thus possible to determine four absolute reflectivities $r_1^s, r_1^p, r_2^s$, and $r_2^p$ and two relative phase shifts $\varphi_1^s - \varphi_2^s$ and $\varphi_1^p - \varphi_2^p$, where $r_1^s, r_1^p, r_2^s$, and $r_2^p$ denoting the reflectivity at the first position P1 for the s-polarization, the reflectivity at the first position P1 for the p-polarization, the reflectivity at the second position P2 for the s-polarization, and the reflectivity at the second position P2 for the p-polarization, respectively, and where $\varphi_1^s$ denotes the reconstructed phase at the first position for the s-polarization, <pi denotes the reconstructed phase at the first position for the p-polarization, $\varphi_2^s$ denotes the reconstructed phase at the second position for the s-polarization and $\varphi_2^p$ denotes the reconstructed phase at the second position for the s-polarization, respectively. Since the absolute phase of a reconstructed image is not retrieved, direct comparison between measured phases of the first synthetic image (s-polarization) and the second synthetic image (p-polarization) is not possible. However, the relative phase shifts, e.g., $\varphi_1^s - \varphi_2^s$ and $\varphi_1^p - \varphi_2^p$, between two structured layers of different materials at one polarization state can be accurately determined from a single reconstructed image IMA1 or IMA2. The measured relative phase shifts, $\phi_1^s - \phi_2^s$ and $\phi_1^p - \phi_2^p$, are caused by a change of the complex refractive index and/or by a height-difference between the spatially separated structured layers STR1, STR2.

Systematic errors when measuring the power of the illumination radiation and detector miscalibration lead to deviations of the absolute reflectivity, $r_1^s, r_1^p, r_2^s$, and $r_2^p$. To remove these systematic errors, the amplitude ratios between the four reflectivities $r_1^s, r_1^p, r_2^s$, and $r_2^p$ are used instead. This gives a measurement of six observables, namely $r_1^s, r_1^p, r_2^s, r_2^p, \varphi_1^s - \varphi_2^s$ and $\varphi_1^p - \varphi_2^p$, from which it is possible to determine the five unknown parameters $h$, $n_1$, $k_1$, $n_2$ and $k_2$. This can be achieved using the following four equations:

$$D_1 := \frac{r_1^s}{r_1^p} = f_1(\theta_i, n_1, k_1) \tag{1}$$

$$D_2 := \frac{r_2^s}{r_2^p} = f_2(\theta_i, n_2, k_2) \tag{2}$$

$$D_3 := \frac{r_1^s}{r_2^s} \exp\left[i(\phi_1^s - \phi_2^s)\right] = f_3(\theta_i, h, n_1, k_1, n_2, k_2) \tag{3}$$

$$D_4 := \frac{r_1^p}{r_2^p} \exp\left[i(\phi_1^p - \phi_2^p)\right] = f_4(\theta_i, h, n_1, k_1, n_2, k_2) \tag{4}$$

where $D_1$ - $D_4$ are four ratios defined by two or more of the six observables $r_1^s, r_1^p, r_2^s, r_2^p, \varphi_1^s - \varphi_2^s$ and $\varphi_1^p - \varphi_2^{\iota}$ ($D_1$ ratio and $D_2$ ratio are real while $D_3$ ratio and $D_4$ ratio are complex); $f_1$ - $f_4$ are physical models from which the ratios $D_1$ - $D_4$ are respectively derived and they are chosen based on a set of reasonable assumptions. One of the assumptions is that all the captured scattering patterns are a result of single-layer reflection from two spatially separated layers STR1, STR2 with different complex refractive indices $ñ_1$ and $ñ_2$. For single-layer reflection, the reflectivities are defined by the Fresnel equations. Furthermore, the models $f_1$ - $f_4$ assume that the two spatially separated structured layers STR1, STR2 can have a relative height difference h and are not covered by an additional layer. The illumination radiation directly reflects at the interface of the propagation medium (e.g., vacuum/air) and the structured layers STR1, STR2.

The physical models $f_1$ - $f_4$ defined by the Fresnel equations are expressed as follows:

$$f_1(\theta_i, n_1, k_1) = \left| \frac{\tilde{n}_{\text{med.}} \cos\theta_i - \tilde{n}_1 \cos\theta_t}{\tilde{n}_{\text{med.}} \cos\theta_i + \tilde{n}_1 \cos\theta_t} \cdot \frac{\tilde{n}_1 \cos\theta_i + \tilde{n}_{\text{med.}} \cos\theta_t}{\tilde{n}_1 \cos\theta_i - \tilde{n}_{\text{med.}} \cos\theta_t} \right| \tag{5}$$

$$f_2(\theta_i, n_2, k_2) = \left| \frac{\tilde{n}_{\text{med.}} \cos\theta_i - \tilde{n}_2 \cos\theta_t}{\tilde{n}_{\text{med.}} \cos\theta_i + \tilde{n}_2 \cos\theta_t} \cdot \frac{\tilde{n}_2 \cos\theta_i + \tilde{n}_{\text{med.}} \cos\theta_t}{\tilde{n}_2 \cos\theta_i - \tilde{n}_{\text{med.}} \cos\theta_t} \right| \tag{6}$$

$$f_3(\theta_i, n_1, k_1, n_2, k_2) = \frac{\tilde{n}_{\text{med.}} \cos\theta_i - \tilde{n}_1 \cos\theta_t}{\tilde{n}_{\text{med.}} \cos\theta_i + \tilde{n}_1 \cos\theta_t} \cdot \frac{\tilde{n}_{\text{med.}} \cos\theta_i + \tilde{n}_2 \cos\theta_t}{\tilde{n}_{\text{med.}} \cos\theta_i - \tilde{n}_2 \cos\theta_t} e^{-i\phi_h} \tag{7}$$

$$f_4(\theta_i, n_1, k_1, n_2, k_2) = \frac{\tilde{n}_1 \cos\theta_i - \tilde{n}_{\text{med.}} \cos\theta_t}{\tilde{n}_1 \cos\theta_i + \tilde{n}_{\text{med.}} \cos\theta_t} \cdot \frac{\tilde{n}_2 \cos\theta_i + \tilde{n}_{\text{med.}} \cos\theta_t}{\tilde{n}_2 \cos\theta_i - \tilde{n}_{\text{med.}} \cos\theta_t} e^{-i\phi_h} \tag{8}$$

where $\tilde{n}_1 = n_1 - ik_1$ denotes the complex refractive index of the material of the first structured layer STR1, $\tilde{n}_2 = n_2 - ik_2$ denotes the complex refractive index of the material of the second structured layer STR2, $\tilde{n}_{med}$ denotes the refractive index of the propagation medium which is approximated to be 1 for vacuum or air, $\theta_1$ denotes the incidence angle of the illumination radiation, k denotes the wavenumber of the illumination radiation,

$\cos\theta_t = \sqrt{1 - (\frac{1}{\tilde{n}_{1,2}} \sin\theta_i)^2}$, $\varphi_h = 2hk\cos\theta_i$

denotes the phase shift resulting from the height difference $h = |h_1 - h_2|$ between the first structured layer STR1 and the second structured layer STR2.

Equations (1) - (4) may be solved by minimizing a loss-function that compares the difference between the measured ratios $D_{1-4}$ with the estimated ratios from the physical model $f_{1-4}$. One example loss-function is based on the $L^2$-norm, minimizing the squared differences of $D_i$ - $f_i$ and its reciprocal $\frac{1}{D_i} - \frac{1}{f_i}$ :

$$L(\theta_i, h, n_1, k_1, n_2, k_2, \vec{D}) = \frac{1}{2} \sum_{j=1}^{4} \left[ (D_j - f_j)^2 + \left( \frac{1}{D_j} - \frac{1}{f_j} \right)^2 \right] \tag{9}$$

For multiple incidence angles, the above loss-function, i.e. equation (9), may be expanded by summing over all measured incident angles $\theta_i$:

$$L_{\text{total}}(h, n_1, k_1, n_2, k_2, \vec{D}) = \sum_{\theta_i} L(\theta_i, h, n_1, k_1, n_2, k_2, \vec{D})$$

$$= \frac{1}{2} \sum_{\theta_i} \sum_{j=1}^{4} \left[ (D_j - f_j)^2 + \left( \frac{1}{D_j} - \frac{1}{f_j} \right)^2 \right] \tag{10}$$

Note that measuring at more incidence angles can improve overall accuracy of the retrieved optical property. More details about how ptychography measurements are performed and the associated arrangements (e.g., as shown in Figures 10A-10C) will be discussed in more detail below. Note also that reconstructing the refractive indices $\tilde{n}_1$, $\tilde{n}_2$ based on equation (10) is not the same as averaging the reconstructed refractive indices $\tilde{n}_1$, $\tilde{n}_2$ retrieved from eq. (9) over the different measurement angles.

The main conceptual difference of the proposed method to conventional ellipsometry is in the use of phase information. Ellipsometry also uses the same equations for $D_1$ and $D_2$, together with at least one more absolute reflectivity measurement. A main advantage of the proposed method is in the measurement of $D_3$ and $D_4$, and the strong constraint on n and $k$ that can be obtained by having accurate spatially resolved phase information about the object. The algorithmic approach outlined above then provides a way to determine n and k for all materials (or more generally stated: at each position on the sample) from the measured data.

It will be appreciated that two similar sets of equations (1) - (10) can be defined respectively for the material pair of the first structured layer STR1 and the substrate layer SUB and for the material pair of the second structural layer STR2 and the substrate layer SUB. As such, it is possible to reconstruct the complex refractive index of the substrate $\tilde{n}_{sub}$, the relative height between the first structural layer STR1 and the substrate layer SUB (which is essentially the height $h_1$ of the first structural layer STR1), and the relative height between the second structural layer STR2 and the substrate layer SUB (which is essentially the height $h_2$ of the second structural layer STR2). Accordingly, the number of equations (e.g., equations (1) - (4)) scales quadratic with the number of materials (or structured layers). Every measured ratio between any two materials defines one equation in the model. For only two materials, this results in four ratios, namely $D_1$ - $D_4$.

Generalizing equations (1) and (2) for N different materials leads to N equations:

$$D_1, D_2 \rightarrow D_j = \frac{r_j^s}{r_j^p} = f_1(\theta_i, n_j, k_j) = f_2(\theta_i, n_j, k_j), \qquad j \in [1, N] \ . \tag{11}$$

Generalizing eq. (3) for N materials leads to $N(N - 1)$ equations:

$$D_3 \rightarrow D_{jk} = \frac{r_{jk}^s}{r_{jk}^s} \exp\left[i(\phi_j^s - \phi_k^s)\right] = f_3(\theta_i, h_{j,k}, n_j, k_j, n_k, k_k),$$

$$(j, k) \in \left\{ j \neq k \mid (j, k) \in [1, N]^2 \right\} \ . \tag{12}$$

Generalizing eq. (4) for N materials leads to $N(N - 1)$ equations:

$$D_4 \rightarrow D_{jk} = \frac{r_{jk}^p}{r_{jk}^p} \exp\left[i(\phi_j^p - \phi_k^p)\right] = f_4(\theta_i, h_{j,k}, n_j, k_j, n_k, k_k),$$

$$(j, k) \in \left\{ j \neq k \mid (j, k) \in [1, N]^2 \right\} \ . \tag{13}$$

The total number of equations $N_{eqs}$ for N materials is therefore given by

$$N_{eqs} = N + N(N - 1) + N(N - 1) = 2N^2 - N \ . \tag{14}$$

In theory, to reconstruct the complex refractive index and height of N materials, 3N - 1 independent equations are required (the factor 3 comes from real and imaginary part of the complex refractive index plus the height of the Nth material). Hence, the number of required equations scales linearly while the number of provided equations scales quadratically. Adding more materials should therefore improve accuracy of the retrieved complex refractive indices.

Note that all the above equations (1)-(13) are defined under the assumption that different materials (or different structured layers) are placed side-by-side (i.e. spatially separated) on a substrate. Similar to ellipsometry, those equations can be adapted for more complex structures comprising a stack of partially transparent thin film materials, provided that sufficient measurements are done. Partially transparent thin films would result in interference upon reflection. Thus, the physical models $f_1$ - $f_4$ may be modified to take account of the propagation of the illumination radiation through different materials which have different Fresnel equations. The main technique to do this is called the transfer matrix method, which essentially is a repetitive procedure that includes multiple reflections. More details about the transfer matrix method can be found in the paper, Steven J. Byrnes, "Multilayer optical calculations", Physics.Computational-Physics, arXiv: 1603.02720, 30 December 2020. More details about how the reflectivites of multiple stacked thin layers are derived can be found in the paper, Michael Tanksalvala, et al., "Nondestructive, high-resolution, chemically specific 3D nanostructure characterization using phase-sensitive EUV imaging reflectometry" Science Advances, 7(5), eabd9667, 2021 (DOI: 10.1126/sciadv.abd9667), which is incorporated herein by reference in its entirety.

In the case where multiple opaque (non-transparent) materials are overlaid on top of one another, the complex refractive index of the top-layer can still be retrieved accurately. The embodiments may still work by adapting the equations using prior knowledge of the sample (e.g., the knowledge of the stack arrangement, the target heights of some or all layers).

Referring back to the foregoing embodiments where optical property of a multi-layer structure are determined based on ptychography measurements in a single polarization state, it has been found that ptychography measurements performed for a single polarization state would be enough to retrieve the optical property if the multi-layer structure comprises four or more materials. This approach has the advantage of not requiring calibration measurement, but this is at the cost of measuring $N^2$ fewer ratios (N is the number of materials present in the multi-layer structure). Performing ptychography measurements for two different (e.g., orthogonal) polarizations enables a much higher accuracy in determining the optical property because $N^2$ more ratios (e.g., $D_j$, $D_{jk}$) are used to determine the optical property.

In one embodiment, the at least two layers of different materials comprise a substrate layer and at least three other layers, said at least three other layers being located on a same top surface of the substrate layer and being spatially separated from one another.

The following paragraphs will describe different ways to obtain one or more pluralities of scattering patterns and the associated respective arrangements (e.g., as shown in Figures 10A-10C) configured for ptychography measurements.

Figures 10A-10C schematically illustrate three example arrangements ARG1-ARG3 configured for polarization sensitive ptychography measurements.

With reference to Figure 10A, a beam of illumination radiation IL is directed towards a sample W (e.g., a wafer) comprising a multi-layer structure MLS (e.g., 407 in Figure 6). The illumination radiation IL may be provided by a radiation source suitable for CDI (e.g., the radiation source 402 shown in Figure 6). The beam of illumination radiation IL passes through a polarization beam splitter PBS and a half waveplate WP before being focused onto the sample W by a focusing element FE. The focusing element FE may be one or more optical lenses, one or more curved mirrors, or a combination of one or more curved mirrors and one or more optical lenses. The polarization beam splitter PBS is configured to transmit a portion of the illumination radiation IL in a first polarization state (e.g., p-polarization) while simultaneously rejecting (or reflecting) a remaining portion of the illumination radiation IL in a second polarization state (e.g., p-polarization). It will be appreciated that where the illumination radiation is linearly polarized, the polarization beam splitter PBS may not be required. The half waveplate WP is operable to rotate or adjust the polarization of the transmitted portion of the illumination radiation IL (e.g., to change the polarization state from p-polarization to s-polarization). In some implementations, one or more of the polarization beam splitter PBS, the half waveplate and the focusing element FE may be comprised in the radiation source RS. Upon interacting with the multi-layer structure MLS of the sample W, a portion SR of the illumination radiation IL is scattered towards and subsequently captured by a detector DET.

Optionally, a polarization filter PF may be placed between the sample W and the detector DET to maximally transmits the scattered radiation SR in a predefined polarization (e.g., s-polarization) while rejecting or blocking the radiation in other polarization states. For example, in the case of the illumination radiation IL is s-polarized, the polarization filter PF may be adjusted (or rotated) to maximally transmit the scattered radiation SR in the s-polarization state. The angle of incidence $\theta_i$ may be varied by either changing the propagation direction of the illumination radiation IL, or preferably by rotating the sample W about Y axis (according to the local coordinate system shown in Figure 10A). The detection arm (including the polarization filter PF and the detector DET) will rotate accordingly to capture the scattered radiation SR, as shown in Figure 10A.

The arrangement ARG1 shown in Figure 10A may enable a sequential acquisition of the at least one first plurality of scattering patterns and the at least one second plurality of scattering patterns.

In an embodiment and with reference to Figure 10A, the step of obtaining the at least one first plurality of scattering patterns may comprises: directing the illumination radiation IL in the first polarization state (e.g., s-polarization) to the multi-layer structure MLS to provide one spot of a first plurality of spots (e.g., S(1) to S(N) shown in Figure 8C) of illumination radiation; capturing with a detector DET radiation scattered RS from the multi-layer structure MLS to obtain one scattering pattern of the first plurality of scattering patterns; displacing the multi-layer structure MLS with respect to the spot of illumination radiation IL, or vice versa, to provide a different spot of the first plurality of spots of illumination radiation IL; and repeating the capturing step and the displacing step until the first plurality of scattering patterns are obtained.

After the at least one first plurality of scattering patterns have been obtained, the polarization state of the illumination radiation IL may be changed from the first polarization state (e.g., s-polarization) to the second polarization state (e.g., p-polarization). The polarization of the illumination radiation IL may be changed by rotating the half waveplate WP.

The step of obtaining the second plurality of scattering patterns may comprise: directing the illumination radiation IL in the second polarization state (e.g., p-polarization) to the multi-layer structure MLS to provide one spot of the second plurality of spots (e.g., S(1) to S(N) shown in Figure 8C) of illumination radiation IL; capturing with the detector DET radiation scattered RS from the multi-layer structure MLS to obtain one scattering pattern of the second plurality of scattering patterns; displacing the multi-layer structure MLS with respect to the spot of illumination radiation IL, or vice versa, to provide a different spot of the second plurality of spots of illumination radiation; and repeating the capturing step and the displacing step until the second plurality of scattering patterns are obtained.

With continued reference to Figure 10A, to collect measurement data for different angles of incidence, the proposed method may further comprise changing the angle of incidence $\theta_i$ and/or wavelength of the illumination radiation IL to one or more different angles, and for each different angle of incidence, repeating the above described directing step, the capturing step, and the displacing step to obtain the at least one first plurality of scattering patterns and the at least one second plurality of scattering patterns. All the scattering patterns may be simultaneously or sequentially transmitted as image data from the detector DET to a processing resource.

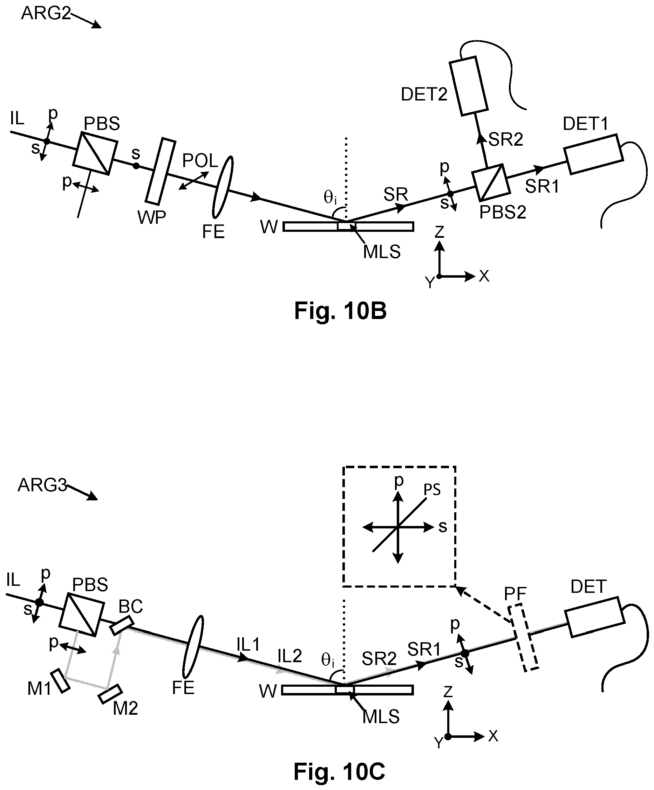

The arrangement ARG2 shown in Figure 10B is a variant of the arrangement ARG1 shown in Figure 10A. The illumination arms of the two arrangements ARG1, ARG2 are substantially the same. However, the detection arm of the arrangement ARG2 shown in Figure 10B comprises a second polarization beam splitter PBS2 and two detectors DET1, DET2. The half waveplate WP may be operable to rotate the polarization of the illumination radiation to a polarization POL between the s-polarization and the p-polarization. The polarization POL may form an angle of 45° with the s-polarization or the p-polarization. Upon interacting with the multi-layer structure MLS of the sample W, a portion SR of the illumination radiation IL is scattered towards and subsequently captured by a detector DET. The scattered radiation SR may comprise a first portion SR1 in the s-polarization and a second portion SR2 in the p-polarization. The second polarization beam splitter PBS may be operable to separate the first portion SR1 and the second portion SR2 of the scattered radiation and direct them respectively to the first detector DET1 and the second detector DET2. The incidence angle of the illumination radiation IL may be varied in the similar manner as the arrangement ARG1 shown in Figure 10A.

The arrangement ARG2 shown in Figure 10B may enable a parallel acquisition of the at least one first plurality of scattering patterns and the at least one second plurality of scattering patterns.

In an embodiment and with reference to Figure 10B, the step of concurrently obtaining the at least one first plurality of scattering patterns and the at least one second plurality of scattering patterns may comprise: directing the illumination radiation IL in a third polarization POL between the first polarization state (e.g., s-polarization) and the second polarization state (e.g., p-polarization) to the multi-layer structure MLS to provide one spot of a first plurality of spots of illumination radiation IL which is also one of a second plurality of spots of illumination radiation; separating radiation scattered SR from the multi-layer structure MLS into a first scattered portion SR1 in the first polarization state (e.g., s-polarization) and a second scattered portion SR2 in the second polarization state (e.g., p-polarization); capturing with a first detector DET1 the first scattered portion SR1 to obtain one scattering pattern of the first plurality of scattering patterns and capturing with a second detector DET2 the second scattered portion SR2 to obtain one scattering pattern of the second plurality of scattering patterns; displacing the multi-layer structure MLS with respect to the spot of illumination radiation, or vice versa, to provide a different spot of the first plurality of spots of illumination radiation which is also a different spot of the second plurality of spots of illumination radiation IL; and repeating the capturing step and the displacing step until the first plurality of scattering patterns and the second plurality of scattering patterns are obtained.

In an embodiment, the third polarization state POL may have a polarization direction forming an angle of 45° with the direction of either s-polarization or p-polarization.

With continued reference to Figure 10B, to collect measurement data for different angles of incidence, the proposed method may further comprise changing the angle of incidence $\theta_i$ and/or wavelength of the illumination radiation IL to one or more different angles, and for each different angle of incidence and/or wavelength of the illumination radiation, repeating the above described the directing step, the separating step, the capturing step, and the displacing step to obtain the at least one first plurality of scattering patterns and the at least one second plurality of scattering patterns. All the scattering patterns may be simultaneously or sequentially transmitted as image data from the detector DET to a processing resource.

The arrangement ARG3 shown in Figure 10C is a further variant of the arrangement ARG1 shown in Figure 10A. In this example arrangement, the beam of the illumination radiation IL may be split into two partially spatially separate beams IL1, IL2 with opposite polarizations (e.g., s-polarization and p-polarization). This may be achieved by using a polarization beam splitter PBS to spatially separate the illumination radiation into a first portion in the first polarization (e.g., s-polarization) and a second portion in the second polarization (e.g., s-polarization). The second portion IL2 may be directed by two mirrors M1, M2 to a beam combining element BC which recombines the first portion and the second portion in such a way that the two portions of the illumination radiation are partially displaced from each other. Upon interacting with the multi-layer structure MLS of the sample W, the first portion IL1 and the second portion IL2 of the illumination radiation are respectively scattered into a first scattered portion SR1 in the first polarization state (e.g., s-polarization) and a second scattered portion SR2 in the second polarization state (e.g., p-polarization). The two differently polarized scattered portions SR1, SR2 may be captured concurrently by the detector DET. Mixed-state ptychography can then be used to retrieve images for each polarization state from a single scan.

Optionally, the arrangement ARG3 may comprise a polarization filter PF oriented in such a way that the polarization state defined by the polarization filter PF is between the first polarization state (e.g., s-polarization) and the second polarization state (e.g., p-polarization) (as shown in Figure 10C). In the case where the first polarization state is s-polarization and the second polarization state is p-polarization, the polarization filter PF may define a polarization state forming an angle of 45° with the s-polarization or the p-polarization. This additional polarization filter PF between the sample W and the detector DET can further enhance the performance of mixed-state ptychography because it projects the two differently polarized scattering patterns to the same polarization, leading them to interfere with each other. After adjusting the forward model of the ptychographic reconstruction algorithm, the reflectivities of the two retrieved images for the two different polarization states have the same global phase. Thus, it becomes feasible to calculate the complex ratios $D_1$ and $D_2$ and with that, the phase differences between the first scattered portion in the first polarization state and the second scattered portion in the second polarization state can be measured. The then acquired phase differences can be viewed as two more equations which should increase accuracy in determining the optical property of the structure.

Similar to the arrangement ARG2 shown in Figure 10B, the arrangement ARG3 may also enable a parallel acquisition of the at least one first plurality of scattering patterns and the at least one second plurality of scattering patterns.

In an embodiment and with reference to Figure 10C, the step of obtaining concurrently the at least one first plurality of scattering patterns and the at least one second plurality of scattering patterns comprises: splitting the illumination radiation IL into a first illumination portion IL1 in the first polarization state (e.g., s-polarization) and a second illumination portion IL2 in the second polarization state (e.g., p-polarization), said first illumination portion IL1 and said second illumination portion IL2 being partially spatially displaced from each other; directing the first illumination portion IL1 and the second illumination portion IL2 to the multi-layer structure MLS to provide one spot of a first plurality of spots of illumination radiation and one spot of a second plurality of spots of illumination radiation, respectively; capturing with a detector DET radiation scattered from the multi-layer structure MLS to obtain concurrently one scattering pattern of the first plurality of scattering patterns and one scattering pattern of the second plurality of scattering patterns; displacing the multi-layer structure MLS with respect to the spots of illumination radiation IL, or vice versa, to provide a different spot of the first plurality of spots of illumination radiation and a different spot of the second plurality of spots of illumination radiation; and repeating the capturing step and the displacing step until the first plurality of scattering patterns and the second plurality of scattering patterns are obtained.

The radiation scattered from the multi-layer structure MLS may comprise a first scattered portion SR1 in the first polarization state and a second scattered portion SR2 in the second polarization state associated with the first illumination portion IL1 and the second illumination portion IL2, respectively. Before reaching the detector DET, the first scattered portion SR2 and the second scattered portion SR2 may pass through a polarization filter PF defining a polarization state between the first polarization state and the second polarization state such that the detector DET may capture a first transmitted portion of the first scattered portion SR1 and a second transmitted portion of the second scattered portion SR2, both transmitted portions having a polarization as defined by the polarization filter PF.

In an embodiment, the intensities of the captured first plurality of scattering patterns and the second plurality of scattering patterns are calibrated against the intensity of the illumination radiation IL.

The concept of making polarization resolved measurements and reconstructing optical property (e.g., complex refractive indices, height) of one or more layers of a multi-layer structure using the polarization resolved measurements can be equally applicable to digital holographic microscopy.

Digital holographic microscopy (DHM) is an imaging technology that combines holography with microscopy. Different from other microscopy methods that record projected images of an object, digital holographic microscopy records holograms formed by interference between object radiation obtained by irradiation of a three-dimensional (3D) object with object radiation and reference radiation that is coherent with the object radiation. Images may be captured using, for example a charge coupled device (CCD) or a complementary metal oxide semiconductor (CMOS). Since the object radiation is radiation scattered from the object, wave-front of the object radiation is therefore modulated or shaped by the object. Said scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm.

An important advantage of hologram-based metrology over intensity-based metrology, as described in examples of Figures 4 and 5, is that hologram-based metrology allows both intensity and phase information of an object to be obtained. With additional phase information, characteristics of the object can be determined with better accuracy. Furthermore, a DHM will allow the use of a simple objective lens, which allows a significant size and weight reduction of the sensor optics compared to a dark field scatterometer. This makes it easier to move the sensor over the wafer, while simultaneously enabling the use of multiple sensors on a single wafer.

The international patent application WO2021121733A1, incorporated herein by reference, discloses a method and metrology apparatus based on a dark field digital holographic microscope (df-DHM) to determine a characteristic, e.g., overlay, of a structure manufactured on a substrate.

In an embodiment, the first scattering or diffraction data may comprise at least one first interference pattern relating to interference between at least one first beam pair, each of the at least one first beam pair comprising a first reference beam and a first scattered beam, the first scattered beam having been scattered from the structure after being illuminated by the illumination radiation. The first reference beam and the first scattered beam of each first beam pair may be at least partially coherent. The one or more first synthetic images of the multi-layer structure may be reconstructed using the at least one first interference pattern.

In an embodiment, the second scattering or diffraction data may comprise at least one second interference pattern relating to interference between at least one second beam pair, each of the at least one second beam pair comprising a second reference beam and a second scattered beam, the second scattered beam having been scattered from the structure after being illuminated by the illumination radiation. The second reference beam and the second scattered beam of each second beam pair may be at least partially coherent. The one or more second synthetic images of the multi-layer structure may be reconstructed using the at least one second interference pattern.

The at least one first interference pattern and the at least one second interference may be obtained from a df-DHM (e.g., as shown in Figure 10 of WO2021121733A1). Each of the at least one first interference pattern and the at least one second interference may comprise two at least partially spatially overlapping interference patterns corresponding respectively to the +1st diffraction order and the -1st diffraction order. The df-DHM may be configured such that the two at least partially spatially overlapping interference patterns can be separated by subsequent data processing, e.g., performed by a processing resource.

In an embodiment, the at least one first interference pattern may be obtained by: illuminating the multi-layer structure with the illumination radiation in the first polarization state to provide the first scattered beam, the first scattered beam having been scattered from the multi-layer structure upon illumination; directing the first reference beam to interfere with the scattered beam so as to form the at least one first interference pattern on the detector; and capturing with the detector the at least one first interference pattern.

In an embodiment, the at least one second interference pattern may be obtained by: illuminating the multi-layer structure with the illumination radiation in the second polarization state to provide the second scattered beam, the second scattered beam having been scattered from the multi-layer structure upon illumination; directing the second reference beam to interfere with the second scattered beam so as to form the at least one second interference pattern on the detector; and capturing with the detector the at least one second interference pattern.

In an embodiment, the proposed method may further comprise: changing an angle of incidence and/or wavelength of the illumination radiation to one or more different angles, and for each different angle of incidence and/or wavelength, repeating the illuminating step, the directing step, and the capturing step to obtain the at least one first interference pattern or the at least one second interference patterns. Similar to the ptychography based embodiments, measuring at more incidence angles and or wavelengths of the illumination radiation can also improve overall accuracy of the retrieved optical property for the DHM based embodiments.

In an embodiment, the proposed method may further comprise changing a polarization state of the illumination radiation from the first polarization state to the second polarization state after the at least one first interference pattern has been obtained.

One embodiment is a method for measuring a parameter of interest, optionally an optical-property-related parameter, optionally a refractive index parameter, of a structure on a substrate. The method comprises steps of (1) Measuring a multiple of first scattered illuminations from multiple illumination spots covering different areas of the structure illuminated from an incident illumination with a first polarization, and optionally each of the multiple illumination spots (partly) overlaps with a least one of the other illumination spots; (2) Measuring a multiple of second scattered illuminations from multiple illumination spots covering different areas of the structure illuminated from the incident illumination with a second polarization, and optionally each of the multiple illumination spots (partly) overlaps with a least one of the other illumination spots, and optionally the second polarization is orthogonal/perpendicular to the first polarization; and (3) Calculating the parameter of interest of the structure based on the measured multiple of first scattered illuminations and the measured multiple of second scattered illuminations. In another embodiment, the second polarization is different than the first polarization but is not orthogonal/perpendicular to the first polarization.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

1. A method of determining an optical property of a multi-layer structure comprising at least two layers of different materials, comprising:

obtaining first scattering data, the first scattering data relating to an illumination of the multi-layer structure with an illumination radiation in a first polarization state with a first wavelength and subsequently capturing radiation scattered from the multi-layer structure;

reconstructing one or more first synthetic images of the multi-layer structure using the first scattering data, each of the one or more first synthetic images comprising amplitude and phase information of the radiation scattered from the multi-layer structure; and

determining the optical property of the multi-layer structure using the one or more first synthetic images, wherein the optical property comprise complex refractive indices of one or more of the at least two layers of the multi-layer structure, and/or relative heights formed between the at least two layers of the multi-layer structure.

2. A method as claimed in clause 1, wherein the first scattering data comprises at least one first interference pattern relating to interference between at least one first beam pair, each of the at least one first beam pair comprising a first reference beam and a first scattered beam, the first scattered beam having been scattered from the structure after being illuminated by the illumination radiation, wherein the first reference beam and first scattered beam of each first beam pair are at least partially coherent; and

wherein the one or more first synthetic images of the multi-layer structure are reconstructed using the at least one first interference pattern.

3. A method as claimed in clause 1, wherein the first scattering data comprises at least one first plurality of scattering patterns, the at least one first plurality of scattering patterns relating to an illumination of the multi-layer structure respectively with at least one first plurality of spots of illumination radiation in the first polarization state and subsequently capturing the radiation scattered from the multi-layer structure for each spot of illumination radiation, wherein each of the at least one first plurality of spots of illumination radiation corresponds to a different angle of incidence and/or a different wavelength and spots of each of the at least one first plurality of spots of illumination radiation are displaced from one another but overlapping from one another, and wherein each scattering pattern of the at least one first plurality of scattering patterns is associated with one spot of the at least one first plurality of spots of illumination radiation; and

wherein the one or more first synthetic images of the multi-layer structure are reconstructed using respectively the at least one first plurality of scattering patterns and knowledge of a relative displacement of each of the at least one first plurality of spots of illumination radiation, each of the one or more first synthetic images comprising amplitude and phase information of the radiation scattered from the multi-layer structure.

4. A method as claimed in any preceding clause, wherein the at least two layers of different materials comprise a substrate layer and at least three other layers, said at least three other layers being located on a same top surface of the substrate layer and being spatially separated from one another.

5. A method as claimed in any preceding clause, further comprising:

obtaining second scattering data, the second scattering data relating to an illumination of the multi-layer structure with illumination radiation in a second polarization state, different to the first polarization state, and subsequently capturing radiation scattered from the multi-layer structure;

reconstructing one or more second synthetic images of the multi-layer structure using the second scattering data, each of the one or more second synthetic images comprising amplitude and phase information of the radiation scattered from the multi-layer structure; and

wherein the optical property of the multi-layer structure are determined using the one or more first synthetic images and the one or more second synthetic images.

6. A method as claimed in clause 5, wherein the second scattering data comprises at least one second interference pattern relating to interference between at least one second beam pair, each of the at least one second beam pair comprising a second reference beam and a second scattered beam, the second scattered beam having been scattered from the structure after being illuminated by the illumination radiation, wherein the second reference beam and second scattered beam of each second beam pair are at least partially coherent; and wherein the one or more second synthetic images of the multi-layer structure are reconstructed using the at least one second interference pattern.

7. A method as claimed in clause 5, wherein the second scattering data comprises at least one second plurality of scattering patterns, the at least one second plurality of scattering patterns relating to an illumination of the multi-layer structure respectively with at least one second plurality of spots of illumination radiation in the second polarization state and subsequently capturing the radiation scattered from the multi-layer structure for each of the at least one second plurality of spots of illumination radiation, wherein each of the at least one second plurality of spots of illumination radiation corresponds to a different angle of incidence and/or different wavelength of the illumination radiation, and spots of each of the at least one second plurality of spots of illumination radiation are displaced from one another but overlapping from one another, and wherein each scattering pattern of the at least one second plurality of scattering patterns is associated with one spot of the at least one second plurality of spots of illumination radiation; and wherein the one or more second synthetic images of the multi-layer structure are reconstructed using respectively the at least one second plurality of scattering patterns and knowledge of a relative displacement of each of the at least one second plurality of spots of illumination radiation.

8. A method as claimed in any preceding clause, wherein the step of determining the optical property of the multi-layer structure further comprises:

determining a reflectivity of each of the at least two layers in the first polarization state and/or the second polarization state, a phase difference between any two of the at least two layers, and a phase shift resulting from a relative height formed between any two of the at least two layers by using the one or more first synthetic images and/or the one or more second synthetic images;

defining one or more sets of functions, wherein each set of functions is associated with two of the at least two layers of the multi-layer structure, and wherein each function comprises a combination of Fresnel equations and relating to an angle of incidence and/or wavelength of the illumination radiation, a relative height formed between the two layers, and complex refractive indices of the two layers in the first polarization state and/or the second polarization state;

calculating a value for each function using the determined reflectivities, the determined phase differences, and/or the determined phase shifts; and

determining a reflective index for each of the at least two layers, and a relative height between any two of the at least two layers by matching the defined functions to the respective determined values.

9. A method as claimed in clause 8, wherein each set of functions comprises:

a first function being a first ratio of a first reflectivity in the first polarization state of a first layer of the at least two layers over a second reflectivity in the second polarization state of the first layer of the at least two layers;

a second function being a second ratio of a third reflectivity in the first polarization state of a second layer of the at least two layers over a fourth reflectivity in the second polarization state of the second layer of the at least two layers;

a third function being a third ratio of the first reflectivity over the third reflectivity multiplied by an exponential function of (the unit imagery multiplied by a difference between a first phase in the first polarization state of the first layer and a third phase in the first polarization state of the second layer); and

a fourth function being a fourth ratio of the second reflectivity over the fourth reflectivity multiplied by an exponential function of (the unit imagery multiplied by a difference between a second phase in the second polarization state of the first layer and a fourth phase in the second polarization state of the second layer).

10. A method as claimed in clause 8 or 9, wherein the matching step comprises minimizing differences between the one or more sets of functions and their respective corresponding determined values.

11. A method as claimed in clause 10, wherein the step of minimizing differences between the one or more sets of functions and their respective corresponding determined values comprises minimizing a loss function proportional to a sum of squared differences of every function and its corresponding determined value and squared differences of the reciprocal of every function and the reciprocal of its corresponding determined value.

12. A method as claimed in any of clauses 5 to 11, wherein the first polarization state and the second polarization state are orthogonal to each other.

13. A method as claimed in any of preceding clauses 7 to 12, wherein the at least one second plurality of scattering patterns are obtained after obtaining the at least one first plurality of scattering patterns.

14. A method as claimed in clause 13, wherein after the at least one first plurality of scattering patterns have been obtained, changing a polarization state of the illumination radiation from the first polarization state to the second polarization state.

15. A method as claimed in any of clauses 3 to 5 and 7 to 14, wherein the at least one first plurality of scattering patterns are obtained by:

directing the illumination radiation in the first polarization state to the multi-layer structure to provide one spot of a first plurality of spots of illumination radiation;

capturing with a detector radiation scattered from the multi-layer structure to obtain one scattering pattern of the first plurality of scattering patterns;

displacing the multi-layer structure with respect to the spot of illumination radiation, or vice versa, to provide a different spot of the first plurality of spots of illumination radiation; and

repeating the capturing step and the displacing step until the first plurality of scattering patterns are obtained.

16. A method as claimed in any of clauses 7 to 15, wherein the second plurality of scattering patterns are obtained by:

directing the illumination radiation in the second polarization state to the multi-layer structure to provide one spot of the second plurality of spots of illumination radiation;

capturing with a detector radiation scattered from the multi-layer structure to obtain one scattering pattern of the second plurality of scattering patterns;

displacing the multi-layer structure with respect to the spot of illumination radiation, or vice versa, to provide a different spot of the second plurality of spots of illumination radiation; and

repeating the capturing step and the displacing step until the second plurality of scattering patterns are obtained.

17. A method as claimed in clause 15 or 16, further comprising:

changing an angle of incidence and/or wavelength of the illumination radiation to one or more different angles, and for each different angle of incidence and/or wavelength, repeating the

directing step, the capturing step, and the

displacing step to obtain the at least one first plurality of scattering patterns or the at least one second plurality of scattering patterns.

18. A method as claimed in any of clauses 15 to 17, wherein the at least one first plurality of scattering patterns or the at least one second plurality of scattering patterns are obtained by:

maximally transmitting a portion of the radiation scattered from the multi-layer structure in the first polarization state or the second polarization state while blocking a remaining portion of the radiation that is not in the first polarization state or the second polarization state.

19. A method as claimed in any of clauses 7 to 18, wherein the at least one first plurality of scattering patterns and the at least one second plurality of scattering patterns are obtained concurrently.

20. A method as claimed in clause 19, wherein the step of obtaining concurrently the at least one first plurality of scattering patterns and the at least one second plurality of scattering patterns comprises:

directing the illumination radiation in a third polarization state between the first polarization state and the second polarization state to the multi-layer structure to provide one spot of a first plurality of spots of illumination radiation which is also one of a second plurality of spots of illumination radiation;

separating radiation scattered from the multi-layer structure into a first scattered portion in the first polarization state and a second scattered portion in the second polarization state;

capturing with a first detector the first scattered portion to obtain one scattering pattern of the first plurality of scattering patterns and capturing with a second detector the second scattered portion to obtain one scattering pattern of the second plurality of scattering patterns;

displacing the multi-layer structure with respect to the spot of illumination radiation, or vice versa, to provide a different spot of the first plurality of spots of illumination radiation which is also a different spot of the second plurality of spots of illumination radiation; and

repeating the capturing step and the displacing step until the first plurality of scattering patterns and the second plurality of scattering patterns are obtained.

21. A method as claimed in clause 20, further comprising:

changing an angle of incidence and/or wavelength of the illumination radiation to one or more different angles, and for each different angle of incidence and/or wavelength, repeating the directing step, the separating step, the

capturing step, and the displacing step to obtain the at least one first plurality of scattering patterns and the at least one second plurality of scattering patterns.

22. A method as claimed in clause 20 or 21, wherein the third polarization state defines a polarization direction having an equal angular difference to polarization directions defined by the first polarization state and the second polarization state, respectively.

23. A method as claimed in clause 22, wherein the polarization direction defined by the third polarization state forms an angle of 45° with the polarization direction defined by the first polarization state and the polarization direction defined the second polarization state.

24. A method as claimed in clause 19, wherein the step of obtaining concurrently the at least one first plurality of scattering patterns and the at least one second plurality of scattering patterns comprises:

splitting the illumination radiation into a first illumination portion in the first polarization state and a second illumination portion in the second polarization state, said first illumination portion and said second illumination portion being partially spatially displaced from each other;

directing the first illumination portion and the second illumination portion to the multi-layer structure to provide one spot of a first plurality of spots of illumination radiation and one spot of a second plurality of spots of illumination radiation, respectively;

capturing with a detector radiation scattered from the multi-layer structure to obtain concurrently one scattering pattern of the first plurality of scattering patterns and one scattering pattern of the second plurality of scattering patterns;

displacing the multi-layer structure with respect to the spot of illumination radiation, or vice versa, to provide a different spot of the first plurality of spots of illumination radiation and a different spot of the second plurality of spots of illumination radiation; and

repeating the capturing step and the displacing step until the first plurality of scattering patterns and the second plurality of scattering patterns are obtained.

25. A method as claimed in clause 24, wherein the radiation scattered from the multi-layer structure comprises a first scattered portion in the first polarization state and a second scattered portion in the second polarization state associated with the first illumination portion and the second illumination portion, respectively; and wherein the step of obtaining concurrently the at least one first plurality of scattering patterns and the at least one second plurality of scattering patterns further comprises: prior to the capturing step, passing the first scattered portion and the second scattered portion through a polarizing element defining a third polarization state between the first polarization state and the second polarization state; and capturing a first transmitted portion of the first scattered portion and a second transmitted portion of the second scattered portion.

26. A method as claimed in any of clauses 7 to 25, wherein intensities of the first plurality of scattering patterns and the second plurality of scattering patterns are calibrated against an input power of the illumination radiation.

27. A method as claimed in any of clauses 2, 6, 8 to 14, wherein the at least one first interference pattern is obtained by:

illuminating the multi-layer structure with the illumination radiation in the first polarization state to provide the first scattered beam, the first scattered beam having been scattered from the multi-layer structure upon illumination; directing the first reference beam to interfere with the scattered beam so as to form the at least one first interference pattern on the detector; and

capturing with the detector the at least one first interference pattern.

28. A method as claimed in any of clauses 2, 6, 8 to 14 and 27, wherein the at least one second interference pattern is obtained by:

illuminating the multi-layer structure with the illumination radiation in the second polarization state to provide the second scattered beam, the second scattered beam having been scattered from the multi-layer structure upon illumination;

directing the second reference beam to interfere with the second scattered beam so as to form the at least one second interference pattern on the detector; and

capturing with the detector the at least one second interference pattern.

29. A method as claimed in clause 27 or 28, further comprising

changing an angle of incidence and/or wavelength of the illumination radiation to one or more different angles, and for each different angle of incidence and/or wavelength, repeating the illuminating step, the directing step, and the

capturing step to obtain the at least one first interference pattern or the at least one second interference patterns.

30. A method as claimed in clause 28 or 29, further comprising changing a polarization state of the illumination radiation from the first polarization state to the second polarization state after the at least one first interference pattern has been obtained.

31. A method for measuring an optical-property-related parameter of a structure on a substrate, comprising

obtaining first scattering data, the first scattering data relating to measuring a multiple of first scattered illuminations from multiple illumination spots covering different areas of the structure illuminated from an incident illumination with a first polarization, wherein each of the multiple illumination spots partly overlaps with a least one of the other illumination spots,
obtaining second scattering data, the second scattering data relating to measuring a multiple of second scattered illuminations from multiple illumination spots covering different areas of the structure illuminated from the incident illumination with a second polarization, wherein each of the multiple illumination spots partly overlaps with a least one of the other illumination spots, and wherein the second polarization is different from the first polarization, and calculating the optical-property-related parameter of the structure based on the first scattering data and the second scattering data.

32. A method as claimed in clause 31, wherein the optical-property-related parameter is a refractive index parameter of the structure.

33. A method as claimed in clause 31 or 32, wherein measuring the multiple of first scattered illuminations and/or measuring the multiple of first scattered illuminations comprises measuring with different angles of incidence of the incident illumination.

34. A method as claimed in clause 31 or 32, wherein measuring the multiple of first scattered illuminations and/or measuring the multiple of first scattered illuminations comprising measuring with different wavelengths of incidence of the incident illumination.

35. A method as claimed in any of clause 31 to 34, wherein the first scattering data and the second scattering data comprising amplitude and phase information of the incident illumination.

36. A computer program comprising program instructions operable to perform the method of any of preceding clauses 1 to 35, when run on a processing resource.

37. A lithographic tool for measuring and/or inferring properties of a patterned structure on a substrate, comprising a non-transient computer program carrier comprising a computer program as claimed in clause 36.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A method of determining an optical property of a multi-layer structure comprising at least two layers of different materials, comprising:

   obtaining first scattering data, the first scattering data relating to an illumination of the multi-layer structure with an illumination radiation in a first polarization state with a first wavelength and subsequently capturing radiation scattered from the multi-layer structure;
   reconstructing one or more first synthetic images of the multi-layer structure using the first scattering data, each of the one or more first synthetic images comprising amplitude and phase information of the radiation scattered from the multi-layer structure; and
   determining the optical property of the multi-layer structure using the one or more first synthetic images, wherein the optical property comprise complex refractive indices of one or more of the at least two layers of the multi-layer structure, and/or relative heights formed between the at least two layers of the multi-layer structure.

2. A method as claimed in claim 1, wherein the first scattering data comprises at least one first interference pattern relating to interference between at least one first beam pair, each of the at least one first beam pair comprising a first reference beam and a first scattered beam, the first scattered beam having been scattered from the structure after being illuminated by the illumination radiation, wherein the first reference beam and first scattered beam of each first beam pair are at least partially coherent; and
   wherein the one or more first synthetic images of the multi-layer structure are reconstructed using the at least one first interference pattern.

3. A method as claimed in claim 1, wherein the first scattering data comprises at least one first plurality of scattering patterns, the at least one first plurality of scattering patterns relating to an illumination of the multi-layer structure respectively with at least one first plurality of spots of illumination radiation in the first polarization state and subsequently capturing the radiation scattered from the multi-layer structure for each spot of illumination radiation, wherein spots of each of the at least one first plurality of spots of illumination radiation are displaced from one another but overlapping from one another, and wherein each scattering pattern of the at least one first plurality of scattering patterns is associated with one spot of the at least one first plurality of spots of illumination radiation; and wherein the one or more first synthetic images of the multi-layer structure are reconstructed using respectively the at least one first plurality of scattering patterns and knowledge of a relative displacement of each of the at least one first plurality of spots of illumination radiation, each of the one or more first synthetic images comprising amplitude and phase information of the radiation scattered from the multi-layer structure.

4. A method as claimed in claim 3, wherein each of the at least one first plurality of spots of illumination radiation corresponds to a different angle of incidence.

5. A method as claimed in claim 3, wherein each of the at least one first plurality of spots of illumination radiation corresponds to a different wavelength of the illumination radiation.

6. A method as claimed in any preceding claim, further comprising:

obtaining second scattering data, the second scattering data relating to an illumination of the multi-layer structure with illumination radiation in a second polarization state, different to the first polarization state, and subsequently capturing radiation scattered from the multi-layer structure;
reconstructing one or more second synthetic images of the multi-layer structure using the second scattering data, each of the one or more second synthetic images comprising amplitude and phase information of the radiation scattered from the multi-layer structure; and
wherein the optical property of the multi-layer structure are determined using the one or more first synthetic images and the one or more second synthetic images.

7. A method as claimed in claim 6, wherein the second scattering data comprises at least one second interference pattern relating to interference between at least one second beam pair, each of the at least one second beam pair comprising a second reference beam and a second scattered beam, the second scattered beam having been scattered from the structure after being illuminated by the illumination radiation, wherein the second reference beam and second scattered beam of each second beam pair are at least partially coherent; and wherein the one or more second synthetic images of the multi-layer structure are reconstructed using the at least one second interference pattern.

8. A method as claimed in claim 6, wherein the second scattering data comprises at least one second plurality of scattering patterns, the at least one second plurality of scattering patterns relating to an illumination of the multi-layer structure respectively with at least one second plurality of spots of illumination radiation in the second polarization state and subsequently capturing the radiation scattered from the multi-layer structure for each of the at least one second plurality of spots of illumination radiation, wherein spots of each of the at least one second plurality of spots of illumination radiation are displaced from one another but overlapping from one another, and wherein each scattering pattern of the at least one second plurality of scattering patterns is associated with one spot of the at least one second plurality of spots of illumination radiation; and
wherein the one or more second synthetic images of the multi-layer structure are reconstructed using respectively the at least one second plurality of scattering patterns and knowledge of a relative displacement of each of the at least one second plurality of spots of illumination radiation.

9. A method as claimed in claim 8, wherein each of the at least one second plurality of spots of illumination radiation corresponds to a different angle of incidence.

10. A method as claimed in claim 8, wherein each of the at least one second plurality of spots of illumination radiation corresponds to a different wavelength of the illumination radiation.

11. A method as claimed in any of claims 1 to 5, further comprising:

obtaining second scattering data, the second scattering data relating to an illumination of the multi-layer structure with illumination radiation with a second wavelength, different to the first wavelength, and subsequently capturing radiation scattered from the multi-layer structure;
reconstructing one or more second synthetic images of the multi-layer structure using the second scattering data, each of the one or more second synthetic images comprising amplitude and phase information of the radiation

EP 4 560 400 A1

scattered from the multi-layer structure; and
wherein the optical property of the multi-layer structure are determined using the one or more first synthetic images and the one or more second synthetic images.

12. A method as claimed in any of claims 6 to 10, wherein the first polarization state and the second polarization state are orthogonal to each other.

13. A method as claimed in any of claims 6 to 10, wherein the first polarization state and the second polarization state are different but are not orthogonal to each other.

14. A method for measuring an optical-property-related parameter of a structure on a substrate, comprising

obtaining first scattering data, the first scattering data relating to measuring a multiple of first scattered illuminations from multiple illumination spots covering different areas of the structure illuminated from an incident illumination with a first polarization, wherein each of the multiple illumination spots partly overlaps with a least one of the other illumination spots,
obtaining second scattering data, the second scattering data relating to measuring a multiple of second scattered illuminations from multiple illumination spots covering different areas of the structure illuminated from the incident illumination with a second polarization, wherein each of the multiple illumination spots partly overlaps with a least one of the other illumination spots, and wherein the second polarization is different from the first polarization, and calculating the optical-property-related parameter of the structure based on the first scattering data and the second scattering data.

15. A computer program comprising program instructions operable to perform the method of any of preceding claims 1 to 14, when run on a processing resource.

**Fig. 1**

**Fig. 2**

**Fig. 3**

**Fig. 4**

SM1

**Fig. 5**

SM1

**Fig. 6**

**Fig. 7**

**Fig. 8A**

(b) **Fig. 8B**

**Fig. 8C**

MLS

$n_2, k_2, h_2$

STR2

$n_1, k_1, h_1$

STR1

SUB

**Fig. 9A**

MLS

h

STR2

$h_2$

STR1

$h_1$

SUB

**Fig. 9B**

IMA1

P2 → +

$n_2, k_2, h_2$

STR2

P1 → +

$n_1, k_1, h_1$

STR1

SUB

**Fig. 9C**

IMA2

Fig. 9D

ARG1

Fig. 10A

Fig. 10B

Fig. 10C

**Europäisches Patentamt**
**European Patent Office**
**Office européen des brevets**

# EUROPEAN SEARCH REPORT

**Application Number**

EP 23 21 2371

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | A. M. MAIDEN: "A new method of high resolution, quantitative phase scanning microscopy", PROC. SPIE 7729, SCANNING MICROSCOPY 2010, 77291I (3 JUNE 2010), vol. 7729, 2 June 2010 (2010-06-02), pages 1-8, XP093163853, DOI: 10.1117/12.853339 | 1-3,15 | INV. G03F7/20 G01N23/00 G02B21/36 G01N21/84 G01N21/956 G01N21/47 |
| Y | * the whole document * | 1,4-13 | |
| X | DE 10 2020 211819 A1 (ZEISS CARL SMT GMBH [DE]) 21 October 2021 (2021-10-21) | 14 | |
| Y | * paragraphs [0024] - [0030], [0034] - [0036], [0058], [0059]; figure 1 * | 6-10,12, 13 | |
| Y | US 2018/164207 A1 (BLUMRICH JÖRG FREDERIK [DE] ET AL) 14 June 2018 (2018-06-14) * paragraphs [0156], [0157] * | 4,9 | |
| Y | WO 2017/025373 A1 (ASML NETHERLANDS BV [NL]) 16 February 2017 (2017-02-16) * paragraph [0073] * | 5,10,11 | **TECHNICAL FIELDS SEARCHED (IPC)** |
| Y | RAMOS T ET AL: "Direct 3D Tomographic Reconstruction and Phase-Retrieval of Far-Field Coherent Diffraction Patterns", ARXIV.ORG, CORNELL UNIVERSITY LIBRARY, 201 OLIN LIBRARY CORNELL UNIVERSITY ITHACA, NY 14853, 30 July 2018 (2018-07-30), XP081120667, * the whole document * | 1 | G03F G01N |

The present search report has been drawn up for all claims

| Place of search | Date of completion of the search | Examiner |
|---|---|---|
| Munich | 20 May 2024 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2371

This annex lists the patent family members relating to the patent documents cited in the above-mentioned European search report.
The members are as contained in the European Patent Office EDP file on
The European Patent Office is in no way liable for these particulars which are merely given for the purpose of information.

20-05-2024

| Patent document cited in search report | Publication date | Patent family member(s) | Publication date |
|---|---|---|---|
| DE 102020211819 A1 | 21-10-2021 | NONE | |
| US 2018164207 A1 | 14-06-2018 | DE 102016224690 A1 | 14-06-2018 |
| | | JP 7132711 B2 | 07-09-2022 |
| | | JP 2018120208 A | 02-08-2018 |
| | | KR 20180067452 A | 20-06-2018 |
| | | US 2018164207 A1 | 14-06-2018 |
| WO 2017025373 A1 | 16-02-2017 | CN 107924119 A | 17-04-2018 |
| | | IL 256818 A | 29-03-2018 |
| | | KR 20180030163 A | 21-03-2018 |
| | | NL 2017269 A | 16-02-2017 |
| | | TW 201721283 A | 16-06-2017 |
| | | US 2017045823 A1 | 16-02-2017 |
| | | WO 2017025373 A1 | 16-02-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 2012044470 A1
- US 6952253 B2
- US 20100328655 A1
- US 20110249244 A1
- US 2011026032 A1
- EP 1628164 A2
- US 7791724 B2
- US 7701577 B2
- US 8115926 B2
- US 8553227 B2
- US 8681312 B2
- US 8792096 B2
- US 8823922 B2
- US 8692994 B2
- US 13533110 B
- US 8797554 B2
- WO 2011012624 A1
- US 2016161863 A1
- US 2011249244 A1
- US 2016370717 A1
- US 2007224518 A1
- US 2019003988 A1
- US 2019215940 A1
- US 2013304424 A1
- US 2014019097 A1, Bakeman
- US 2010241396 A1
- US 7792246 B2
- US 8908910 B2
- US 8917393 B2
- US 8942449 B2
- US 9029745 B2
- WO 2021121733 A1

**Non-patent literature cited in the description**

- **LEMAILLET et al.** Intercomparison between optical and X-ray scatterometry measurements of FinFET structures. *Proc. of SPIE*, 2013, 8681
- **SHEFFIELD. D. CLAUS et al.** Ptychography: a novel phase retrieval technique, advantages and its application. *Proc. SPIE 8001, International Conference on Applications of Optics and Photonics*, 26 July 2011, 800109
- Coherence and partial coherence - what do we need. **IAN MCNULTY**. Center for Nanoscale Materials. Argonne National Laboratory, 21 October 2013
- Partial coherence in diffractive X-ray imaging: towards biomolecular structure determination. **HARRY QUINEY**. ARC Centre for Coherent X-ray Science, School of Physics. The University of Melbourne, 11 August 2015
- **L. W. WHITEHEAD et al.** Diffractive Imaging Using Partially Coherent X Rays. *Phys. Rev. Lett.*, 2009, vol. 103, 243902
- **STEVEN J. BYRNES**. Multilayer optical calculations. *Physics.Computational-Physics, arXiv: 1603.02720*, 30 December 2020
- **MICHAEL TANKSALVALA et al.** Nondestructive, high-resolution, chemically specific 3D nanostructure characterization using phase-sensitive EUV imaging reflectometry. *Science Advances*, 2021, vol. 7 (5), eabd9667